# EUROPEAN PATENT APPLICATION

(11) **EP 4 579 758 A1**
(43) Date of publication of application: **02.07.2025**
(21) Application number: 24174844.1
(22) Date of filing: 08.05.2024
(51) Int. Cl.: H01L 29/739, H01L 29/06, H01L 21/331, H01L 29/08

(54) **BIPOLAR JUNCTION FIELD EFFECT TRANSISTOR AND MANUFACTURING METHOD THEREFOR**

(30) Priority: 28.12.2023 CN 202311825872
(71) Applicant: Suzhou Watech Electronics Co., Ltd., Suzhou, Jiangsu 215125 (CN)
(72) Inventor: QI, Jinwei, Suzhou, 215125 (CN); LIU, Qian, Suzhou, 215125 (CN); LAN, Jinlong, Suzhou, 215125 (CN)
(74) Representative: Michalski Hüttermann & Partner Patentanwälte mbB

(57) **Abstract**

Disclosed are a bipolar junction field effect transistor and a manufacturing method therefor. The bipolar junction field effect transistor includes a drift region of a first doping type, formed in a cell area and a termination area of the bipolar junction field effect transistor; a plurality of pillar regions of a second doping type, extended in a vertical direction, spaced out in a lateral direction, and arranged in a drift region of a first doping type; a first doping type region and a well region of the second doping type formed inversely, successively arranged on the top of the pillar region in the cell area from near to far; and in the termination area, a field oxide layer provided above the drift region of the first doping type, wherein the pillar region in the termination area is in contact with the field oxide layer.

## Description

### TECHNICAL FIELD

The present disclosure relates to the technical field of semiconductor devices, and more particularly to a bipolar junction field effect transistor and a manufacturing method therefor.

### BACKGROUND

The bipolar devices refer to devices that can conduct two carriers of electrons and holes. Specifically, the current flow in bipolar devices is contributed by both electrons and holes. In bipolar transistors, electrons mainly participate in the current flow in the collector region, while holes mainly participate in the current flow in the base region. In bipolar junction field effect transistors (BJFET), electrons and holes also participate in current flow, but their working mechanism is different from that of bipolar transistors.

Hole carrier refers to a kind of charge carrier in semiconductors, and its essence is the formation of hole deficiency (lack of electron) in hole conduction bands. Unlike electrons, holes have a positive charge sign, and their conduction speed is slower than that of electrons. In bipolar devices, both electron and hole contributions are essential.

IGBT Insulated Gate Bipolar Transistor is a power semiconductor device that combines the characteristics of metal oxide field effect transistor (MOSFET) and bipolar transistor (BJT). IGBT has an insulated gate structure, which regulates the ability of current to flow through the main current channel by controlling the current at the gate. In IGBT, the electron flows from N-type materials to P-type materials, this bipolar current conduction mode makes it adapted for high-voltage and high-current situations. By controlling the voltage at the gate, the IGBT can be turned on or off, thereby controlling the current flow. IGBT is commonly used in power amplification, power conversion, and control situations due to high input impedance and controllable conduction capability while being able to handle high-power current. This makes it an important device in the power electronics field for driving motors, frequency converters, inverters, and other high-power situations.

Superjunction: Superjunction (SJ) is a design structure of power MOSFET and IGBT devices. By forming a series of staggered P-N junctions between N-type and P-type doped layers, a higher barrier voltage and a lower leakage current are formed, thereby improving device performance. Superjunction technology can improve switching speed, reduce on-resistance, reduce switching loss, increase barrier voltage, and reduce leakage current, etc. It is one of the important technologies in high-performance power devices at present.

Termination: Termination (Terminal) is a structure for the high-power chip to ensure that the chip as a whole has the target voltage-bearing capacity, which is mainly located in the edge area of the chip and around the chip as a whole ring. The withstand voltage of power devices is limited by the concentration of the electric field at the bend of the PN junction, which needs to be improved by designing a reasonable termination structure. Commonly used termination technologies comprise field limiting ring (FLR) technology, field plate (FP) technology, junction terminal extension (JTE) technology, variation of lateral doping (VLD) technology, and RESURF technology.

In recent years, with the continuous expansion of fields, the demand for high-voltage power devices has been increasing. In order to develop high-performance power devices that meet the above requirements, superjunction IGBTs with superjunction drift regions combine the advantages of FS-IGBTs and superjunctions to achieve high withstand voltage and low loss to provide a new direction for further improvement of IGBT performance. Constrained by the conventional fabrication technology for the devices, there is a big problem in the consistency of the superjunction structure in the device, which leads to a large fluctuation in the voltage-bearing capacity of the device. In actual production, the above-mentioned process fluctuations can easily cause low-yield problems in mass-produced products, seriously limiting the mass-produced shipment. Therefore, in order to be compatible with conventional process fluctuations, it is urgent to improve the conventional superjunction structure, comprehensively improve the voltage-bearing capacity of the product by the new structural design, and effectively improve the product yield.

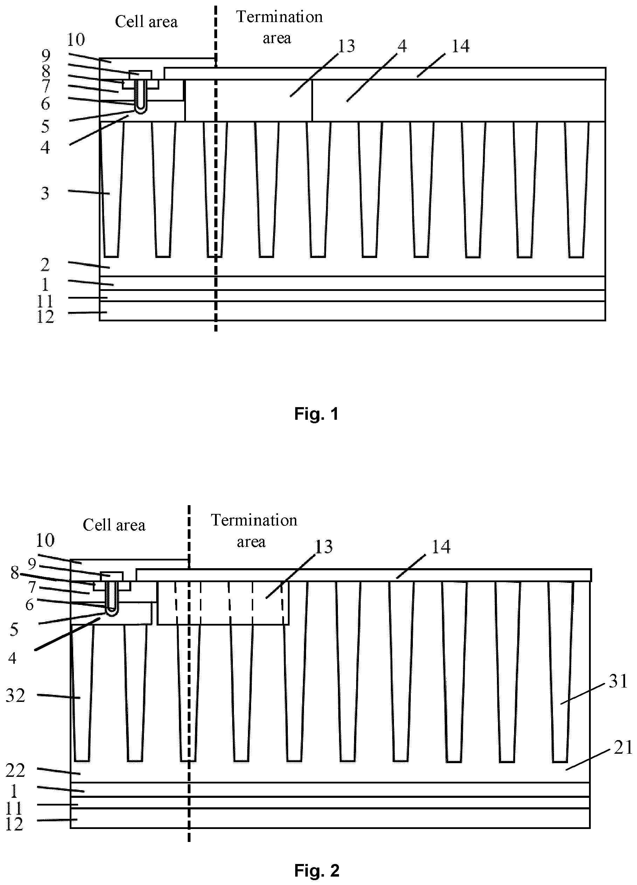

Superjunction IGBT is a new generation of high-speed IGBT design technology, and the excellent electrical performance thereof has been verified by experiments. Fig. 1 is a cross-sectional view of a conventional superjunction IGBT. The conventional superjunction IGBT structure generally comprises a cell area and a termination area, as shown in Fig. 1, where 1 is a P- collector region, 2 is an N- drift region, 3 is a P-type superjunction region, and 4 is a second epitaxy, 5 is a gate oxide layer, 6 is a gate electrode poly, 7 is a Pwell, 8 is an N+ emitter, 9 is a dielectric layer, 10 is an emitter electrode metal, 11 is a P+ collector electrode, 12 is a collector electrode metal, 13 is a termination P-type main junction region, and 14 is field oxide.

In the conventional superjunction IGBT termination area, in the vertical direction, mainly comprises the field oxide 14, the second epitaxy 4, the P-type superjunction region 3, the N- drift region 2, the P- collector region 1, the P + collector electrode 11 and the collector electrode metal 12 from top to bottom. The voltage-bearing capacity of the termination area mainly depends on the part of "second epitaxy 4, P-type superjunction region 3, and N- drift region 2". The thicker the P-type superjunction region 3, the stronger the voltage-bearing capacity of the device. However, in the conventional structure, due to the limitation of the growth process of the second epitaxy 4, an entire layer of the second epitaxy 4 covering the device is formed in the cell area and the termination area. The termination P-type main junction region 13 and Pwell 7 are reprocessed based on the second epitaxy 4. Therefore, as shown in Fig. 1, there is a part of the second epitaxy 4 in the termination area, so that the P-type superjunction region 3 in the termination area must be located below the second epitaxy 4 of the termination area, thereby causing the height of the P-type superjunction region 3 to be low. That is to say, because there must be the second epitaxy 4 in the termination area of the conventional superjunction IGBT, under the premise of a certain chip thickness, there is an upper limit to the height of the P-type superjunction region 3 in the termination area, which seriously limits the improvement of the voltage-bearing capacity of the termination area. As a bipolar transistor, superjunction IGBT must have an N-type structure layer, which acts as a hole carrier barrier layer, increasing the carrier concentration in the drift region and reducing the on-voltage drop. The second epitaxy 4 of the conventional superjunction IGBT is an N-type structural layer.

Therefore, the voltage-bearing capacity of the termination area of the conventional superjunction IGBT is limited, which is a technical problem that one skilled in the art urgently needs to solve.

The above-mentioned information disclosed in the background is only to enhance the understanding of the background of the present disclosure, and therefore it may contain information that has not formed prior art known to one having ordinary skill in the art.

### SUMMARY

The embodiment of the present disclosure provides a bipolar junction field effect transistor and a manufacturing method therefor, so as to solve the technical problem that the voltage-bearing capacity of the termination area of the conventional superjunction IGBT is limited.

According to an embodiment of the present disclosure, a bipolar junction field effect transistor is provided, comprising:
a plurality of pillar regions of a second doping type, extended in a vertical direction and spaced out in a lateral direction, and arranged in a drift region of a first doping type;
a first doping type region and a well region of the second doping type formed inversely, successively arranged on the top of the pillar region in the cell area from near to far; and
in the termination area, a field oxide layer is provided above the drift region of the first doping type, where the pillar region in the termination area is in contact with the field oxide layer.

According to the embodiment of the present disclosure, a manufacturing method for a bipolar junction field effect transistor is also provided, comprising the following steps:
forming a drift region of a first doping type, where the drift region is formed in the cell area and the termination area of the bipolar junction field effect transistor;
forming a plurality of pillar regions of a second doping type, each of the pillar regions extended in a vertical direction and spaced out in a lateral direction, and arranged in the drift region of the first doping type;
successively forming a first doping type region and a well region of the second doping type formed inversely on the top of the pillar region in the cell area from near to far; and
in the termination area, forming a field oxide layer above the drift region of the first doping type, where the pillar region in the termination area is in contact with the field oxide layer.

The embodiments of the present disclosure have the following technical effects due to the adoption of the above technical solutions:

In a case where the thicknesses of the bipolar junction field effect transistors in the background and the embodiment of the present disclosure are the same, the pillar region in the termination area of the present disclosure is located below the field oxide layer, that is, the pillar region in the termination area is directly connected to the bottom of the field oxide layer. In the background, the second epitaxy is first provided under the field oxide layer, and the P-type superjunction region (i.e., the pillar region) can only be directly connected to the second epitaxy. In this way, in a case where the thicknesses of the bipolar junction field effect transistors of the background and the embodiment of the present disclosure are the same, the pillar region in the termination area of the present disclosure is higher than the P-type superjunction region of the background, and the drift region in the termination area is also higher than the drift region of the background, and the voltage-bearing capacity of the termination area of the bipolar junction field effect transistor according to the embodiment of the present disclosure is stronger.

### BRIEF DESCRIPTION OF THE DRAWINGS

The accompanying drawings described herein are used to provide further understanding of the disclosure and to form a part of the disclosure, and the illustrative embodiments of the disclosure and their explanations are used to explain the disclosure and do not constitute an undue qualification of the disclosure. In the drawings:
Fig. 1 is a schematic diagram of the conventional superjunction IGBT.
Fig. 2 is a schematic diagram of a bipolar junction field effect transistor according to an embodiment of the present disclosure.
Fig. 3 is a schematic diagram of forming a drift region of an entire layer and forming a pillar region of the bipolar junction field effect transistor according to the embodiment of the present disclosure.
Fig. 4 is a schematic diagram of forming a first doping type initial region 40.
Fig. 5 is a schematic diagram of forming a first doping type region 4 and a well region 7.
Fig. 6 is a simulation diagram of the IGBT device of the embodiment of the present disclosure and the conventional superjunction IGBT device of the background.
Fig. 7 is a schematic diagram of the breakdown voltages of a plurality of IGBT devices according to embodiments of the present disclosure on one wafer.
Fig. 8 is a schematic diagram of breakdown voltages of a plurality of conventional superjunction IGBT devices of the background on one wafer of the same size as the wafer of Fig. 7.

### REFERENCES IN THE DRAWINGS:

### In background:

1 is a P- collector region, 2 is a N- drift region, 3 is a P-type superjunction region, 4 is a second epitaxy, 5 is a gate oxide layer, 6 is a gate poly, 7 is a Pwell, 8 is a N+ emitter, 9 is a dielectric layer, 10 is an emitter metal, 11 is a P+ collector, 12 is a collector metal, 13 is a termination P-type main junction region, 14 is a field oxygen.

In the embodiment:
collector region 1, drift region 21 in termination area, drift region 22 in the cell area, pillar region 31, pillar region 32 in the cell area;
first doping type initial region 40, first doping type region 4, gate oxide layer 5, gate electrode 6, well region 7, emitter electrode 8;
gate dielectric layer 9, emitter electrode metal 10, collector electrode 11, collector electrode metal 12;
termination second doping type main junction region 13, field oxide layer 14.

### DETAILED DESCRIPTION OF THE EMBODIMENTS

In order to make the technical proposal and advantages of the embodiments of the present disclosure clearer, the following exemplary embodiments of the present disclosure will be described in further detail in conjunction with the accompanying drawings. Obviously, the described embodiments are only a part of the embodiments of the present disclosure, not an exhaustive list of all embodiments. It should be noted that the embodiments of the present disclosure and the features of the embodiments may be combined with each other without conflict.

### Embodiment I

As shown in Figs. 2, 3, 4, and 5, the bipolar junction field effect transistor of the embodiment of the present disclosure comprises:
a drift region of a first doping type semiconductor, formed in a cell area and a termination area of the bipolar junction field effect transistor;
a plurality of pillar regions of a second doping type semiconductor, extended in a vertical direction and spaced out in a lateral direction, and arranged in a drift region of a first doping type;
a first doping type region 4 and a well region 7 of the second doping type formed inversely, successively arranged on the top of the pillar region 32 in the cell area from near to far; and
in the termination area, a field oxide layer 14 provided above the drift region of the first doping type, where the pillar region 31 in the termination area is in contact with the field oxide layer 14. The pillar region (31, 32) of the second doping type located in the cell area being defined as a pillar region (32) in the cell area, the drift region (21, 22) of the first doping type located in the cell area being defined as a drift region (22) in the cell area. Similarly, the pillar region (31, 32) of the second doping type located in the termination area is defined as a pillar region (31) in the termination area, the drift region (21, 22) of the first doping type located in the termination area is defined as a drift region (21) in the termination area.

In a case where the thicknesses of the bipolar junction field effect transistors in the background and the embodiment of the present disclosure are the same, the pillar region 31 in the termination area of the present disclosure is located below the field oxide layer 14, that is, the pillar region 31 in the termination area is directly connected to the bottom of the field oxide layer 14. In the background, the second epitaxy 4 is first provided under the field oxide layer 14, and the P-type superjunction region 3 (i.e., the pillar region) can only be directly connected to the second epitaxy 4. In this way, in a case where the thicknesses of the bipolar junction field effect transistors according to the background and the embodiment of the present disclosure are the same, the pillar region 31 in the termination area of the present disclosure is higher than the P-type superjunction region 3 of the background, and the drift region 21 in the termination area is also higher than the drift region 2 of the background, and the voltage bearing capacity of the termination area of the bipolar junction field effect transistor according to the embodiment of the present disclosure is stronger.

Specifically, the step of arranging a plurality of pillar regions of the second doping type extended in the vertical direction and spaced in the lateral direction in the drift region of the first doping type, comprises the following steps:
forming a deep groove downwards from the top surface of the drift region, and
forming the pillar region 31 of the second doping type inside the deep groove.

Specifically, the first doping type region 4 and the second doping type well region 7 are formed in such a manner that:
forming a first doping type initial region 40 in the upper part of the drift region and the pillar region in the cell area; and
inversely forming a well region 7 of the second doping type in the upper part of the first doping type initial region 40, the part of the first doping type initial region 40 being located below the well region 7 as the first doping type region 4.

The part of the pillar region in the cell area below the first doping type region 4 is defined as the pillar region 32 in the cell area, and the pillar region 31 in the termination area is higher than the pillar region 32 in the cell area.

Correspondingly, the part of the drift region in the cell area below the first doping type region 4 is defined as the drift region 22 in the cell area, and the drift region 21 in the termination area is higher than the drift region 22 in the cell area.

The bipolar junction field effect transistor shown in Fig. 2 is used as an IGBT device to illustrate the technical effect. The gate electrode 6 is connected to a positive voltage, and a trench is formed in the well region 7 near the surface of the gate oxide layer 5. The electrons in the emitter electrode 8 enter the drift region 22 in the cell area through the trench. At the same time, a large number of holes are injected by the collector electrode 11 into the drift region 22 in the cell area, and flow to the emitter electrode 8 through the pillar region 32 in the cell area. The existence of the first doping type region 4 of the bipolar junction field effect transistor according to the embodiment of the present disclosure separates the pillar region 32 in the cell area and the well region 7. The doping type of the first doping type region 4 is opposite to the pillar region. There is a pn junction barrier, which prevents holes from flowing to the emitter electrode. Therefore, there are a large number of electrons and holes in the drift region 22 in the cell area and the pillar region 32 in the cell area. A large injection effect occurs in the drift region 22 in the cell area and the pillar region 32 in the cell area, and the on-voltage drop of the device is greatly reduced.

Without the presence of the first doping type region 4, the pillar region 32 in the cell area is directly connected to the well region 7, and the hole flows directly to the emitter electrode through the pillar region 32 in the cell area. This mode is similar to a unipolar device. In this way, there is no large injection effect in the drift region 22 in the cell area and the pillar region 32 in the cell area, resulting in a large on-voltage drop of the device.

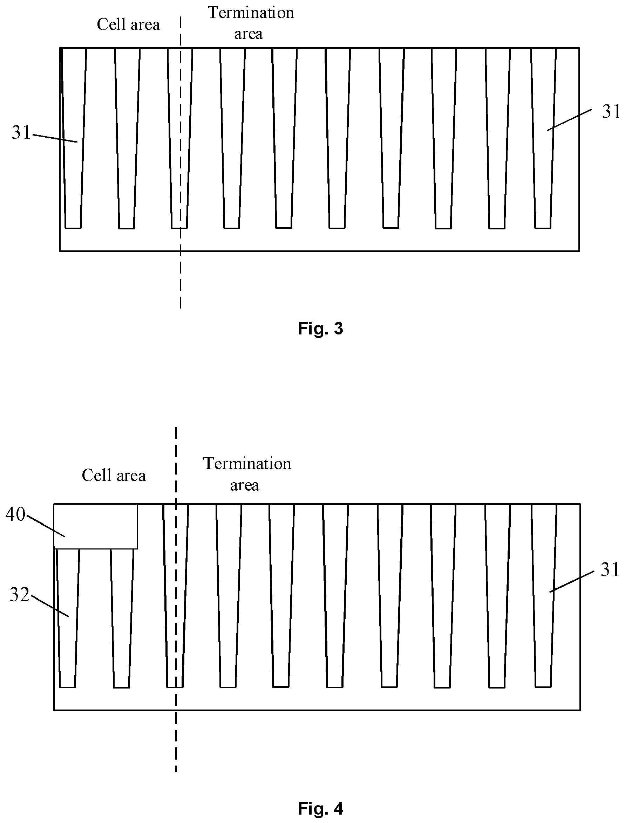

The first doping type initial region 40 is formed in such a manner that:
As shown in Fig. 4, downwardly from the top surface of the drift region and the pillar region in the cell area, the upper parts of the drift region and the pillar region in the cell area are transformed into the first doping type initial region 40 by injection.

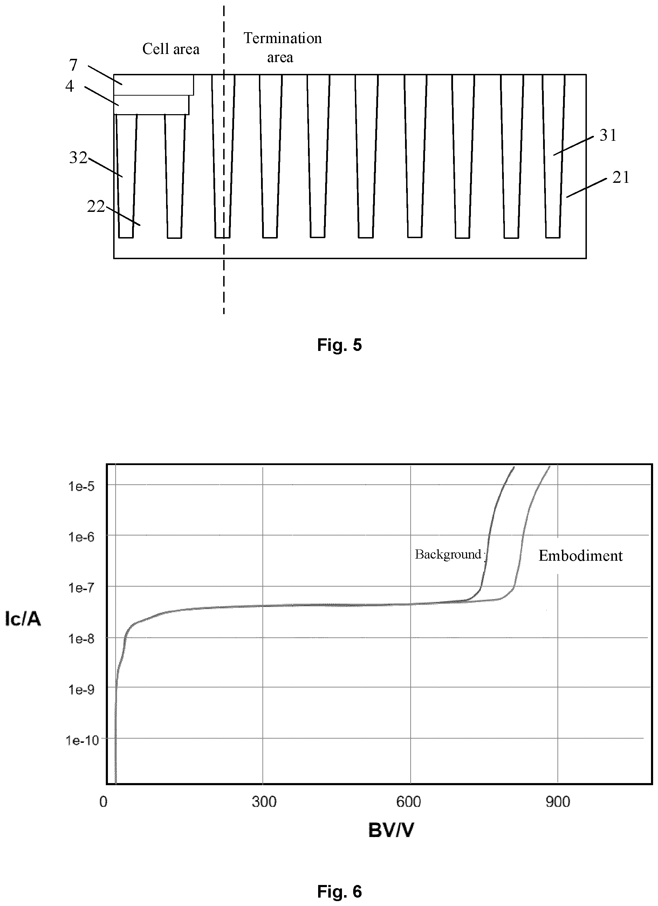

The well region 7 of the second doping type is formed in such a manner that:
As shown in Fig. 5, downwardly from the top surface of the first doping type initial region 40, the upper part of the first doping type initial region 40 is inverted to form the well region 7 of the second doping type by injection.

The forming steps of the first doping type region 4 of the bipolar junction field effect transistor according to the embodiment of the present disclosure:
First, the first doping type initial region 40 is formed by injection. The injection process is characterized in that the position and size of the first doping type initial region 40 can be precisely controlled by the position and size of the injection window, so that the size and position of the first doping type initial region 40 in the lateral direction can be accurately controlled. The first doping type initial region 40 is only limited in the cell area and does not enter the termination area.

After that, downwardly from the top of the first doping type initial region 40, the upper part of the first doping type initial region is inverted to form the well region 7 of the second doping type by injection, and the position and size of the well region 7 of the second doping type can also be precisely controlled. The first doping type initial region is located below the well region 7 is defined as the first doping type region 4. In this way, the position and size of the first doping type region 4 can be precisely controlled, and the first doping type region 4 can be precisely controlled in the cell area without appearing in the termination area. The position and size of the well region 7 of the second doping type can also be precisely controlled in the cell area. Also, the part of the cell area where the pillar region is located below the first doping type region 4 is defined as the pillar region 32 in the cell area, since the pillar region 32 in the cell area is only a lower part of the original pillar region in the cell area. Accordingly, the pillar region 31 in the termination area is higher than the pillar region 32 in the cell area. Correspondingly, the part of the drift region in the cell area below the first doping type region 4 is defined as the drift region 22 in the cell area, and the drift region 21 in the termination area is higher than the drift region 22 in the cell area. The voltage bearing capacity of the termination area mainly depends on the part of "the first doping type region 4 + the pillar region 31 in the termination area + the drift region 21 in the termination area". In a case where the thicknesses of the bipolar junction field effect transistors according to the background and the embodiment of the present disclosure are the same, the pillar region 31 in the termination area of the present disclosure is higher than the P-type superjunction region 3 of the background, and the drift region 21 in the termination area is also higher than the drift region 2 of the background, and the voltage bearing capacity of the termination area of the bipolar junction field effect transistor according to the embodiment of the present disclosure is stronger.

Specifically, the drift region 21 in the termination area is higher than the drift region 22 in the cell area, so that the withstand voltage level of the termination area can be effectively improved, thereby realizing the effect of strengthening the voltage bearing capacity of the bipolar junction field effect transistor.

In the embodiment, as shown in Fig. 2, the bottom surface of the pillar region 31 in the termination area is even with the bottom surface of the pillar region 32 in the cell area, and the bottom surface of the pillar region 31 in the termination area is even with the bottom surface of the pillar region 32 in the cell area, which can ensure that the electric field at the bottom of the bipolar junction field effect transistor transitions smoothly when the bipolar junction field effect transistor is under reverse voltage, avoiding the occurrence of an electric field extreme value area, and effectively improving chip reliability.

The bottom of the drift region 21 in the termination area is even with the bottom of the drift region 22 in the cell area.

The bottom of the drift region 21 in the termination area is even with the bottom of the drift region 22 in the cell area, so that in a case where the device is under reverse voltage, the electric field at the bottom of the chip can be smoothly transitioned, the electric field extreme value region can be avoided, and the reliability of the chip can be effectively improved.

In the embodiment, as shown in Fig. 2, the first doping type is N-type, and the second doping type is P-type.

Correspondingly, the drift region 21 in the termination area, the drift region 22 in the cell area, and the first doping type region 4 are all N-type.

The pillar region 31 in the termination area, the pillar region 32 in the cell area, and the well region 7 are all P-type.

In implementation, as shown in Fig. 2, the bipolar junction field effect transistor is an IGBT device. The IGBT device further comprises:
a termination second doping type main junction region 13, connected to the well region 7.

The depth of the termination second doping type main junction region 13 surface has a range of greater than or equal to 3 microns, and less than or equal to 5 microns.

The width of the termination second doping type main junction region 13 in the arrangement direction of the cell area and the termination area is ranging from greater than or equal to 30 microns and less than or equal to 60 microns. If the termination second doping type main junction region 13 is too wide, the chip area will be wasted, and if it is too narrow, the subsequent layout will not be adapted for wiring. The injection depth is related to the energy of the injection. The deeper the energy required, the greater the damage to the surface of the device, thereby affecting the reliability of the device. That is, as shown in Fig. 2, the width of the termination second doping type main junction region 13 in the direction parallel to the paper surface has a range of greater than or equal to 30 microns and less than or equal to 60 microns.

In one embodiment, as shown in Fig. 2, the IGBT device further comprises:
a collector region 1 of the second doping type, located below the drift region 21 in the termination area and the drift region 22 in the cell area;
a collector electrode 11 of the second doping type, located below the collector region 1;
a collector electrode metal 12, located below the collector electrode 11 ;
a trench, formed downwards from the top face of the well region 7;
a gate oxide layer 5, formed on the bottom and side walls of the trench;
a gate electrode 6, formed in a space enclosed by the gate oxide layer 5;
an emitter electrode 8 of the first doping type, formed around the well region 7;
a gate dielectric layer 9, formed above the gate electrode 6; and
an emitter electrode metal 10, formed above the gate dielectric layer 9.

In the embodiment, as shown in Fig. 2, the ratio of the top end width of the pillar region 32 in the cell area to the width between the top ends of the pillar regions 32 in the cell area is 4:5, and the ratio of the top end width of the pillar region 31 in the termination area to the width between the top ends of the pillar regions 31 in the termination area is 4:5. That is, the ratio of pillar region to pillar region interval is 4:5.

The doping concentrations of the pillar region 32 in the cell area and the pillar region 31 in the termination area are 4.5×10¹⁵/cm⁻³.

At present, with the ratio of pillar region to pillar region interval being 4:5, the process is relatively mature. Under the current ratio of pillar region to pillar region interval and epitaxial doping concentration, the doping concentration of the pillar region being 4.5×10¹⁵/cm⁻³ is the best condition for charge balance, that is, the breakdown voltage of the device is the highest under this condition.

Fig. 6 is a simulation diagram of the IGBT device of the embodiment of the present disclosure and a conventional superjunction IGBT device of the background. The IGBT device of the embodiment of the present disclosure has the same structure except for the first doping type region 4 and the conventional superjunction IGBT device except for the second epitaxy 4. As shown in Fig. 6, the horizontal axis is the breakdown voltage (BV) and the vertical axis is the collector electrode current. The breakdown voltage of the IGBT device of the embodiment of the present disclosure is much larger than that of the conventional superjunction IGBT device.

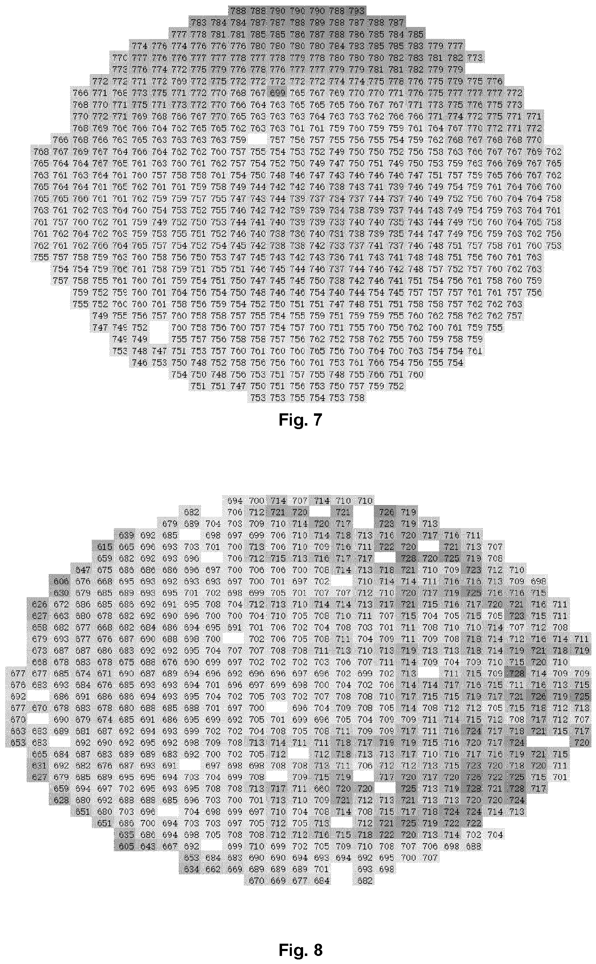

Fig. 7 is a schematic diagram of the breakdown voltages of a plurality of IGBT devices according to the embodiment of the present disclosure on one wafer. Fig. 8 is a schematic diagram of breakdown voltages of a plurality of the conventional superjunction IGBT devices of background on one wafer of the same size as the wafer of Fig. 7. The IGBT device of the embodiment of the present disclosure has the same structure except for the first doping type region 4 and the conventional superjunction IGBT device except for the second epitaxy 4.

The circles of Figs. 7 and 8 represent one wafer.

Each block in Fig. 7 represents one physical device of the IGBT device of the embodiment of the present disclosure, and each block in Fig. 8 represents one physical device of the conventional superjunction IGBT device of the background. The numbers on each block in Figs. 7 and 8 represent breakdown voltages. No number on the block represents a broken device. The smaller the number on the block, the lower the breakdown voltage is. The larger the number on the block, the higher the breakdown voltage is.

In Fig. 8, there are many blocks without numbers, that is, there are many broken devices. There are some blocks with smaller numbers, that is, there are some devices with lower breakdown voltages. There are some blocks with smaller numbers, blocks with larger numbers, and blocks with relatively larger numbers, that is, there are some devices with higher breakdown voltages with the lower breakdown voltage, the higher breakdown voltage, and relatively higher breakdown voltage. The median value of the breakdown voltage of Fig. 8 is 706 V.

In Fig. 7, there are very few blocks without numbers, that is, there are very few broken devices. There are also very few blocks with small numbers, that is, there are very few devices with low breakdown voltages. There are some blocks with small numbers, that is, there are some with the lower breakdown voltage. The blocks with large numbers and blocks with larger numbers are the main ones, that is, there are many devices with higher breakdown voltages and relatively higher breakdown voltages. The median value of the breakdown voltage of Fig. 7 is 760V.

Therefore, the breakdown voltage of the bipolar junction field effect transistor of the embodiment of the present disclosure is relatively higher, and the product stability is also relatively higher.

### Embodiment II

The manufacturing method for the bipolar junction field effect transistor according to the embodiment of the present disclosure, for preparing the bipolar junction field effect transistor of Embodiment I, comprises the following steps:
forming a drift region of a first doping type, where the drift region is formed in the cell area and the termination area of the bipolar junction field effect transistor;
forming a plurality of pillar regions of a second doping type, each of the pillar regions extended in a vertical direction, spaced out in a lateral direction, and arranged in the drift region of the first doping type;
successively forming a first doping type region 4 and a well region 7 of the second doping type formed inversely on the top of the pillar region 32 in the cell area from near to far; and
in the termination area, forming a field oxide layer 14 above the drift region of the first doping type, where the pillar region 31 in the termination area is in contact with the field oxide layer 14.

The pillar region 31 in the termination area is directly connected with the field oxide layer 14, that is, the pillar region 31 in the termination area is directly connected to the surface of the chip of the bipolar junction field effect transistor.

In the background, the P-type superjunction regions 3 are all connected to the second epitaxy 4, and the second epitaxy 4 is connected to the field oxide layer 14. That is to say, in the background, the P-type superjunction region 3 is connected to the second epitaxy 4, and the second epitaxy 4 is connected to the surface of the chip.

In a case where the thicknesses of the bipolar junction field effect transistors according to the background and the embodiment of the present disclosure are the same, the pillar region 31 in the termination area of the present disclosure is higher than the P-type superjunction region 3 of the background, and the drift region 21 in the termination area is also higher than the drift region 2 of the background, and the voltage bearing capacity of the termination area of the bipolar junction field effect transistor according to the embodiment of the present disclosure is stronger.

Specifically, the step of forming a plurality of pillar regions of the second doping type, each of the pillar regions extended in a vertical direction and spaced out in a lateral direction, and arranged in the drift region of the first doping type, specifically comprises the steps of:
forming a deep groove downwards from the top surface of the drift region, and forming the pillar region of the second doping type inside the deep groove.

In the embodiment, the step of successively forming the first doping type region 4 and the well region 7 of the second doping type inversely formed on the top of the pillar region 32 in the cell area from near to far, comprises the following steps:
downwardly from the top surface of the drift region and the pillar region in the cell area, transforming the upper parts of the drift region and the pillar region in the cell area into the first doping type initial region 40 by injection.

The upper part of the first doping type initial region 40 is inverted downwardly from the top surface of the first doping type initial region 40 to form the well region 7 of the second doping type by injection, the first doping type initial region being located below the well region 7 as the first doping type region 4. The part of the pillar region in the cell area below the first doping type region 4 is defined as the pillar region 32 in the cell area. The pillar region 31 in the termination area is higher than the pillar region 32 in the cell area.

The first doping type initial region 40 is formed by injection, and the injection process has features of the position and size of the first doping type initial region 40 can be precisely controlled by the position and size of the injection window, so that the size and position of the first doping type initial region 40 in the lateral direction can be precisely controlled, and the first doping type initial region 40 is only limited in the cell area and does not enter the termination area.

After that, downwardly from the top of the first doping type initial region 40, the upper part of the first doping type initial region is inverted to form the well region 7 of the second doping type by injection, and the position and size of the well region 7 of the second doping type can also be precisely controlled. The first doping type initial region is located below the well region 7 is defined as the first doping type region 4. In this way, the position and size of the first doping type region 4 can be precisely controlled, and the first doping type region 4 can be precisely controlled in the cell area without appearing in the termination area. The position and size of the well region 7 of the second doping type can also be precisely controlled in the cell area. Also, the part of the cell area where the pillar region is located below the first doping type region 4 is defined as the pillar region 32 in the cell area, since the pillar region 32 in the cell area is only a lower part of the original pillar region in the cell area. Accordingly, the pillar region 31 in the termination area is higher than the pillar region 32 in the cell area. Correspondingly, the part of the drift region in the cell area below the first doping type region 4 is defined as the drift region 22 in the cell area, and the drift region 21 in the termination area is higher than the drift region 22 in the cell area. The voltage bearing capacity of the termination area mainly depends on the part of "the first doping type region 4 + the pillar region 31 in the termination area + the drift region 21 in the termination area". In a case where the thicknesses of the bipolar junction field effect transistors according to the background and the embodiment of the present disclosure are the same, the pillar region 31 in the termination area of the present disclosure is higher than the P-type superjunction region 3 of the background, and the drift region 21 in the termination area is also higher than the drift region 2 of the background, and the voltage bearing capacity of the termination area of the bipolar junction field effect transistor according to the embodiment of the present disclosure is stronger.

In practice, the manufacturing method for the bipolar junction field effect transistor further comprises the following steps:
forming the termination second doping type main junction region 13 connected to the well region 7;
forming the collector region 1 of the second doping type, the collector region 1 being located below the drift region 21 in the termination area and below the drift region 22 in the cell area;
forming the collector electrode 11 of the second doping type located below the collector region 1;
forming the collector electrode metal 12 located below the collector electrode 11;
forming the trench downwards from the top face of the well region 7;
forming the gate oxide layer 5 on the bottom and side walls of the trench;
forming the gate electrode 6 in a space enclosed by the gate oxide layer 5;
forming the emitter electrode 8 of the first doping type around the well region 7;
forming the gate dielectric layer 9 above the gate electrode 6;
forming the emitter electrode metal 10 above the gate dielectric layer 9.

In the description of the present disclosure and its embodiments, it is to be understood that the terms "top", "bottom", "height" and the like indicate the orientation or positional relationship based on the orientation or positional relationship shown in the accompanying drawings, only for the purpose of facilitating the description of the present disclosure and simplifying the description, and do not indicate or imply that the device or element referred to must have a specific orientation, be constructed and operated in a specific orientation, and therefore cannot be understood as a limitation of the present disclosure.

In this disclosure and its embodiments, unless otherwise expressly stipulated and limited, the terms "arrange", "mount", "connect", "attach", "fix" and other terms should be understood in a broad sense, for example, it can be a fixed connection, a detachable connection, or integrated connection. It can be a mechanical connection, an electrical connection, or communication. It can be directly connected or indirectly connected through an intermediate medium, and it can be a connection between two elements or an interaction relationship between two elements. For one having ordinary skill in the art, the specific meanings of the above-mentioned terms in the disclosure can be understood on a case-by-case basis.

In the present disclosure and embodiments thereof, unless otherwise expressly specified and defined, the first feature may comprise the first and second features in direct contact "above" or "below" the second feature or may comprise the first and second features not in direct contact but in contact with another feature between them. Also, the first feature being "above", "on" and "upper" the second feature comprises the first feature being directly above and obliquely above the second feature, or merely indicating that the first feature is horizontally higher than the second feature. The first feature being "below", "under" and "beneath" the second feature comprises the first feature being directly above and obliquely above the second feature, or merely indicating that the first feature is horizontally lower than the second feature.

## Claims

1. A bipolar junction field effect transistor comprising:
a drift region (21, 22) of a first doping type, formed in a cell area and a termination area of the bipolar junction field effect transistor;
a plurality of pillar regions (31, 32) of a second doping type, extended in a vertical direction, spaced out in a lateral direction, and arranged in the drift region (21, 22) of a first doping type;
a first doping type region (4) and a well region (7) of the second doping type formed inversely, successively arranged on the top of the pillar region (32) in the cell area from near to far; and
in the termination area, a field oxide layer (14) provided above the drift region (21, 22) of the first doping type, wherein the pillar region (31) in the termination area is in contact with the field oxide layer (14).

2. The bipolar junction field effect transistor according to claim 1, wherein the pillar region (32) in the cell area is located below the first doping type region (4), and the pillar region (31) in the termination area is higher than the pillar region (32) in the cell.

3. The bipolar junction field effect transistor according to claim 1, wherein the first doping type region (4) and the second doping type well region (7) are formed in such a manner that:
downwardly from a top surface of the drift region (22) and the pillar region (32) in the cell area, transforming upper parts of the drift region (22) and the pillar region (32) in the cell area into the first doping type initial region (40) by injection;
downwardly from a top surface of the first doping type initial region (40), inversely forming upper parts of the first doping type initial region (40) into a well region (7) of the second doping type by injection, the first doping type initial region (40) located below the well region (7) being defined as the first doping type region (4).

4. The bipolar junction field effect transistor according to claim 1, wherein the drift region (22) in the cell area is located below the first doping type region (4); and
the drift region (21) in the termination area is higher than the drift region (22) in the cell area.

5. The bipolar junction field effect transistor according to claim 1, wherein a bottom surface of the pillar region (31) in the termination area is even with a bottom surface of the pillar region (32) in the cell area; or
a bottom of the drift region (21) in the termination area is even with a bottom of the drift region (22) in the cell area.

6. The bipolar junction field effect transistor according to any one of claims 1 to 5, wherein the first doping type is N-type and the second doping type is P-type.

7. The bipolar junction field effect transistor according to any one of claims 1 to 6, further comprising:
a termination second doping type main junction region (13), connected to the well region (7).

8. The bipolar junction field effect transistor according to any one of claims 1 to 7, further comprising:
a collector region (1) of the second doping type, located below the drift region (21) in the termination area and the drift region (22) in the cell area;
a collector electrode (11) of the second doping type, located below the collector region (1);
a collector electrode metal (12), located below the collector electrode (11);
forming the trench downwards from the top face of the well region (7);
a gate oxide layer (5), formed on a bottom and side walls of the trench;
a gate electrode (6), formed in a space enclosed by the gate oxide layer (5);
an emitter electrode (8) of the first doping type, formed around the well region (7);
a gate dielectric layer (9), formed above the gate electrode (6); and
an emitter electrode metal (10), formed above the gate dielectric layer (9).

9. The bipolar junction field effect transistor according to claim 7, wherein a depth of the termination second doping type main junction region (13) has a range of greater than or equal to 3 microns and less than or equal to 5 microns; or
a width of the termination second doping type main junction region (13) in an arrangement direction of the cell area and the termination area has a range of greater than or equal to 30 microns and less than or equal to 60 microns.

10. The bipolar junction field effect transistor according to any one of claims 1 to 9, wherein a ratio of a top end width of the pillar region (32) in the cell area to a width between top ends of the pillar regions (32) in the cell area is 4:5;
a ratio of a top end width of the pillar region (31) in the termination area to a width between top ends of the pillar regions (31) in the termination area is 4:5; or
doping concentrations of the pillar region (32) in the cell area and the pillar region (31) in the termination area are 4.5×10¹⁵/cm⁻³.

11. A manufacturing method for a bipolar junction field effect transistor, comprising:
forming a drift region (21, 22) of a first doping type, wherein the drift region is formed in a cell area and a termination area of the bipolar junction field effect transistor;
forming a plurality of pillar regions (31, 32) of a second doping type, each of the pillar regions (31, 32) extended in a vertical direction, spaced out in a lateral direction, and arranged in the drift region (21, 22) of the first doping type;
successively forming a first doping type region (4) and a well region (7) of the second doping type formed inversely, on the top of the pillar region (32) in the cell area from near to far; and
in the termination area, forming a field oxide layer (14) above the drift region (21, 22) of the first doping type, wherein the pillar region (31) in the termination area is in contact with the field oxide layer (14).

12. The manufacturing method according to claim 11, wherein the step of successively forming a first doping type region (4) and a well region (7) of the second doping type formed inversely, on the top of the pillar region (32) in the cell area from near to far, comprises:
downwardly from the top surface of the drift region (22) and the pillar region (32) in the cell area, transforming the upper parts of the drift region (22) and the pillar region (32) in the cell area into the first doping type initial region (40) by injection; and
downwardly from a top surface of the first doping type initial region (40), inversely forming upper parts of the first doping type initial region (40) into the well region (7) of the second doping type by injection, the first doping type initial region (40) being located below the well region (7) as the first doping type region (4);
wherein the pillar region (32) in the cell area is located below the first doping type region (4), and the pillar region (31) in the termination area is higher than the pillar region (32) in the cell area.

13. The manufacturing method according to claim 12, further comprising:
forming the termination second doping type main junction region (13) connected to the well region (7);
forming the collector region (1) of the second doping type, the collector region (1) being located below the drift region (21) in the termination area and below the drift region (22) in the cell area;
forming the collector electrode (11) of the second doping type located below the collector region (1);
forming the collector electrode metal (12) located below the collector electrode (11);
forming the trench downwards from the top face of the well region (7);
forming the gate oxide layer (5) on the bottom and side walls of the trench;
forming the gate electrode (6) in a space enclosed by the gate oxide layer (5);
forming the emitter electrode (8) of the first doping type around the well region (7);
forming the gate dielectric layer (9) above the gate electrode (6); and
forming the emitter electrode metal (10) above the gate dielectric layer (9).
